(19) **Europäisches Patentamt / European Patent Office / Office européen des brevets**

(11) **EP 4 195 277 B1**

(12) # EUROPEAN PATENT SPECIFICATION

(45) Date of publication and mention
of the grant of the patent:
**29.10.2025 Bulletin 2025/44**

(51) International Patent Classification (IPC):
***H10D 86/40*** (2025.01)   ***H10D 86/60*** (2025.01)
***H10K 59/126*** (2023.01)

(21) Application number: **22189874.5**

(52) Cooperative Patent Classification (CPC):
**H10D 86/423; H10D 86/60; H10K 59/126**

(22) Date of filing: **11.08.2022**

(54) **DISPLAY APPARATUS HAVING AN OXIDE SEMICONDUCTOR**

ANZEIGEGERÄT MIT EINEM OXIDHALBLEITER

APPAREIL D'AFFICHAGE DOTÉ D'UN SEMI-CONDUCTEUR À OXYDE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.12.2021 KR 20210177510**

(43) Date of publication of application:
**14.06.2023 Bulletin 2023/24**

(73) Proprietor: **LG Display Co., Ltd.
Seoul 150-721 (KR)**

(72) Inventor: **KIM, Jae Hyun
Paju-si, Gyeonggi-do 10845 (KR)**

(74) Representative: **Viering, Jentschura & Partner
mbB
Patent- und Rechtsanwälte
Am Brauhaus 8
01099 Dresden (DE)**

(56) References cited:
**KR-A- 20150 101 418    US-A1- 2014 183 476
US-A1- 2021 320 162**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

# Description

## CROSS-REFERENCE TO RELATED APPLICATIONS

This application claims the benefit of and claims priority to Republic of Korea Patent Application No. 10-2021-0177510 filed on December 13, 2021.

## BACKGROUND

### Field

The present disclosure relates to a display apparatus in which at least one of thin film transistors of a pixel driving circuit includes an oxide semiconductor.

### Discussion of the Related Art

Generally, a display apparatus provides an image to user. For example, the display apparatus may include at least one light-emitting device. The light-emitting device may emit light displaying a specific color. For example, the light-emitting device may include a first electrode, a light-emitting layer and a second electrode, which are sequentially stacked.

The light-emitting device may be disposed on a pixel area of a device substrate. Pixel driving circuits for controlling the operation of the light-emitting device may be disposed in the pixel area of the device substrate. The light-emitting device may be electrically connected to the pixel driving circuit. The pixel driving circuits may supply a driving current corresponding to a data signal to the light-emitting device according to a scan signal. For example, the pixel driving circuit may include a plurality of thin film transistor and a storage capacitor.

In order to prevent leakage current in a still image, at least one of the thin film transistors constituting the pixel driving circuit may include an oxide semiconductor. For example, a driving thin film transistor generating the driving current corresponding to the data signal may include a semiconductor pattern made of an oxide semiconductor. However, in the thin film transistor including an oxide semiconductor, a current variation value according to a voltage applied to the gate electrode may be large. That is, in the display apparatus in which the semiconductor pattern of the driving thin film includes an oxide semiconductor, a spot may occur in low grayscale.

And, if a thickness of a gate insulating layer disposed between the semiconductor pattern and the gate electrode of the driving thin film transistor is controlled to reduce the current variation value according to a voltage applied to the gate electrode of the driving thin film transistor, characteristics of a switching thin film transistor being formed simultaneously with the driving thin film transistor is deteriorated by a thickness variation of the gate insulating layer. Thus, in the display apparatus, the quality of the image may be deteriorated.

US 2014/0183476 Al describes a thin film transistor comprising a gate electrode formed on an oxide semiconductor layer such that a first surface of the oxide semiconductor layer faces the gate electrode, a source electrode and a drain electrode are electrically connected to the oxide semiconductor layer, respectively, the oxide semiconductor layer, gate electrode, source electrode and drain electrode are arranged in a coplanar transistor configuration , and a light-blocking element is also arranged to shield a second surface of the oxide semiconductor layer from external light.

US 2021/0320162 Al describes a display device including a substrate, a first conductive layer on the substrate and including a lower light blocking pattern and a first signal line, a buffer layer on the first conductive layer, a semiconductor layer on the buffer layer and including a first semiconductor pattern and a second semiconductor pattern separated from the first semiconductor pattern, an insulating layer on the semiconductor layer and including an insulating layer pattern, a second conductive layer on the insulating layer and including a second signal line, a planarization layer on the second conductive layer, and a third conductive layer on the planarization layer and including an anode electrode, wherein the first semiconductor pattern is electrically connected to the lower light blocking pattern by the anode electrode, and at least a portion of the second semiconductor pattern is isolated from and overlaps each of the first signal line and the second signal line.

KR 2015 0101418 A describes a display device in which a first thin film transistor equipped with a poly-silicon semiconductor material and a second thin film transistor equipped with an oxide semiconductor material are arranged on the same board, wherein a barrier layer having a hydrogen barrier and/or etch prevention function is disposed.

## SUMMARY

Accordingly, the present disclosure is directed to a display apparatus that substantially obviates one or more problems due to limitations and disadvantages of the related art.

An object of the present disclosure is to provide a display apparatus including an oxide semiconductor capable of preventing the occurrence of the spot in low grayscale.

Another object of the present disclosure is to provide a display apparatus capable of reducing the current variation value according to a voltage applied to a gate electrode of a driving thin film transistor, without changing characteristics of a switching thin film transistor.

Additional advantages, objects, and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

To achieve these objects and other advantages and in accordance with the purpose of the present disclosure, as embodied and broadly described herein, there is provided a display apparatus according to claim 1. Further embodiments of the disclosure are described in the dependent claims. In an aspect of the present disclosure, there is provided a display apparatus comprising a device substrate. A first light-blocking pattern and an upper buffer layer are disposed on the device substrate. The first light-blocking pattern is disposed on a pixel area of the device substrate. The upper buffer layer covers the first light-blocking pattern. A driving thin film transistor is disposed on the pixel area of the device substrate, for example on the upper buffer layer of the pixel area. The driving thin film transistor includes a driving semiconductor pattern overlapping with the first light-blocking pattern. A first intermediate insulating layer is disposed between the device substrate and the upper buffer layer. The first intermediate insulating layer includes a first opening overlapping with the first light-blocking pattern and the driving semiconductor pattern. The first opening has a size larger than the first light-blocking pattern and the driving semiconductor pattern.

A switching thin film transistor may be disposed on the upper buffer layer of the pixel area. The switching thin film transistor may include a switching semiconductor pattern. The switching semiconductor pattern may be spaced away from the driving semiconductor pattern. The first intermediate insulating layer may include a portion overlapping with the switching semiconductor pattern.

The switching semiconductor pattern may include the same material as the driving semiconductor pattern.

A second light-blocking pattern may be disposed between the device substrate and the first intermediate insulating layer. The second light-blocking pattern may overlap the switching semiconductor pattern.

The second light-blocking pattern may include the same material as the first light-blocking pattern.

A separation insulating layer may be disposed between the device substrate and the second light-blocking pattern. The separation insulating layer may extend between the device substrate and the first light-blocking pattern.

A second intermediate insulating layer may be disposed between the first intermediate insulating layer and the upper buffer layer. The second intermediate insulating layer may include a second opening overlapping with the first opening.

A driving source electrode of the driving thin film transistor may be electrically connected to the first light-blocking pattern.

A capacitance of a first parasitic capacitor between the first light-blocking pattern and the driving semiconductor pattern may be larger than a capacitance of a second parasitic capacitor between the driving semiconductor pattern and a driving gate electrode of the driving thin film transistor.

The first light-blocking pattern may be disposed in the opening of the first insulating layer. The driving thin film transistor may be disposed on the upper buffer layer. The display apparatus may further comprise a first switching thin film transistor disposed on the upper buffer layer. The driving thin film transistor may include a driving semiconductor pattern overlapping with the first light-blocking pattern. The first switching thin film transistor may include a first switching semiconductor pattern being spaced away from the opening. An over-coat layer may be disposed on the first switching thin film transistor and the driving thin film transistor. A light-emitting device may be disposed on the over-coat layer. The light-emitting device may be electrically connected to the driving thin film transistor.

The driving semiconductor pattern and the first switching semiconductor pattern may include an oxide semiconductor.

A second switching thin film transistor may be disposed between the device substrate and the over-coat layer. The second switching thin film transistor may include a second switching semiconductor pattern and a gate electrode overlapping with a portion of the second switching semiconductor pattern. A gate insulating layer may be disposed between the device substrate and the intermediate insulating layer. The gate insulating layer may extend between the second switching semiconductor pattern and the gate electrode.

The second switching semiconductor pattern may include a material different from the driving semiconductor pattern and the first switching semiconductor pattern.

A second light-blocking pattern overlapping with the first switching semiconductor pattern may be spaced away from the first light-blocking pattern. The second light-blocking pattern may be disposed on the same layer as the gate electrode of the second switching thin film transistor.

The second light-blocking pattern may include the same material as the gate electrode of the second switching thin film transistor.

The first light-blocking pattern may be disposed on a layer different from the second light-blocking pattern.

In another aspect of the present disclosure, there is provided a display apparatus. The display apparatus includes a first light-blocking pattern and a second light-blocking pattern disposed on a device substrate. One or more insulating layers is disposed on the first light-blocking pattern and the second light-blocking pattern. The display apparatus also includes a first thin-film transistor on the one or more insulating layers, the first thin-film transistor including a first semiconductor pattern overlapping with the first light-blocking pattern, the first semiconductor pattern including an oxide semiconductor and electrically connected to a light-emitting device. The display apparatus further includes a second thin-film transistor on the one or more insulating layers, the second thin-film transistor including a second semiconductor pattern overlapping with the second light-blocking pattern. At least a portion of one or more intermediate insulating layers may be disposed between the second light-blocking pattern and the second thin-film transistor, where a distance between the first light-blocking pattern and the first semiconductor pattern is shorter than a distance between the second light-blocking pattern and the second semiconductor pattern.

The first thin-film transistor may be a driving transistor for driving the light-emitting device and the second thin-film transistor may be a switching transistor.

The one or more insulating layers may comprise an upper buffer layer, wherein the first semiconductor pattern and the second semiconductor pattern may be disposed on the upper buffer layer, and the second semiconductor pattern may include an oxide semiconductor.

The one or more intermediate insulating layers may be formed with an opening, the first light-blocking pattern may be disposed within the opening, and the first semiconductor pattern may be overlapped with the opening.

A side surface of the one or more intermediate insulating layers may be located between the first light-blocking pattern and the second light-blocking pattern.

The one or more insulating layers may include a second separating layer on the first light-blocking pattern and the second light-blocking pattern, and an upper buffer layer on the second separating layer, wherein the portion of the one or more intermediate insulating layers may be disposed between the second separating layer and the upper buffer layer.

A third thin-film transistor may be disposed on the device substrate, the third thin-film transistor including a third semiconductor pattern including poly-Si.

A separation insulating layer may be disposed on the third thin-film transistor, wherein the first light-blocking pattern and the second light-blocking pattern may be disposed on the separation insulating layer.

The third thin-film transistor may further include a gate electrode and at least a portion of a lower gate insulating layer, wherein the first light-blocking pattern and the second light-blocking pattern may be disposed on the lower gate insulating layer.

The first thin-film transistor and the second thin-film transistor may be disposed in a pixel area, and the third thin-film transistor may be disposed in a bezel area.

The first light-blocking pattern may be disposed below the second light-blocking pattern.

## BRIEF DESCRIPTION OF THE DRAWINGS

The accompanying drawings, which are included to provide a further understanding of the present disclosure and are incorporated in and constitute a part of this application, illustrate embodiment(s) of the present disclosure and together with the description serve to explain the principle of the present disclosure.

FIG. 1 is a view schematically showing a display apparatus according to an embodiment of the present disclosure.
FIG. 2 is a cross-section according to I-I' of FIG. 1 according to an embodiment of the present disclosure.
FIG. 3 is an enlarged view of P1 region in FIG. 2 according to an embodiment of the present disclosure.
FIG. 4 is an enlarged view of P2 region in FIG. 2 according to an embodiment of the present disclosure.
FIGS. 5 to 9 are views showing the display apparatus according to another embodiment of the present disclosure, respectively.

## DETAILED DESCRIPTION OF EMBODIMENTS

Hereinafter, details related to the above objects, technical configurations, and operational effects of the embodiments of the present disclosure will be clearly understood by the following detailed description with reference to the drawings, which illustrate some embodiments of the present disclosure. Here, the embodiments of the present disclosure are provided in order to allow the technical sprit of the present disclosure to be satisfactorily transferred to those skilled in the art, and thus the present disclosure may be embodied in other forms and is not limited to the embodiments described below.

In addition, the same or extremely similar elements may be designated by the same reference numerals throughout the specification, and in the drawings, the lengths and thickness of layers and regions may be exaggerated for convenience. It will be understood that, when a first element is referred to as being "on" a second element, although the first element may be disposed on the second element so as to come into contact with the second element, a third element may be interposed between the first element and the second element.

Here, terms such as, for example, "first" and "second" may be used to distinguish any one element with another element. However, the first element and the second element may be arbitrary named according to the convenience of those skilled in the art without departing the technical sprit of the present disclosure.

The terms used in the specification of the present disclosure are merely used in order to describe particular embodiments, and are not intended to limit the scope of the present disclosure. For example, an element described in the singular form is intended to include a plurality of elements unless the context clearly indicates otherwise. In addition, in the specification of the present disclosure, it will be further understood that the terms "comprises" and "includes" specify the presence of stated features, integers, steps, operations, elements, components, and/or combinations thereof, but do not preclude the presence or addition of one or more other features, integers, steps, operations, elements, components, and/or combinations.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

(Embodiment)

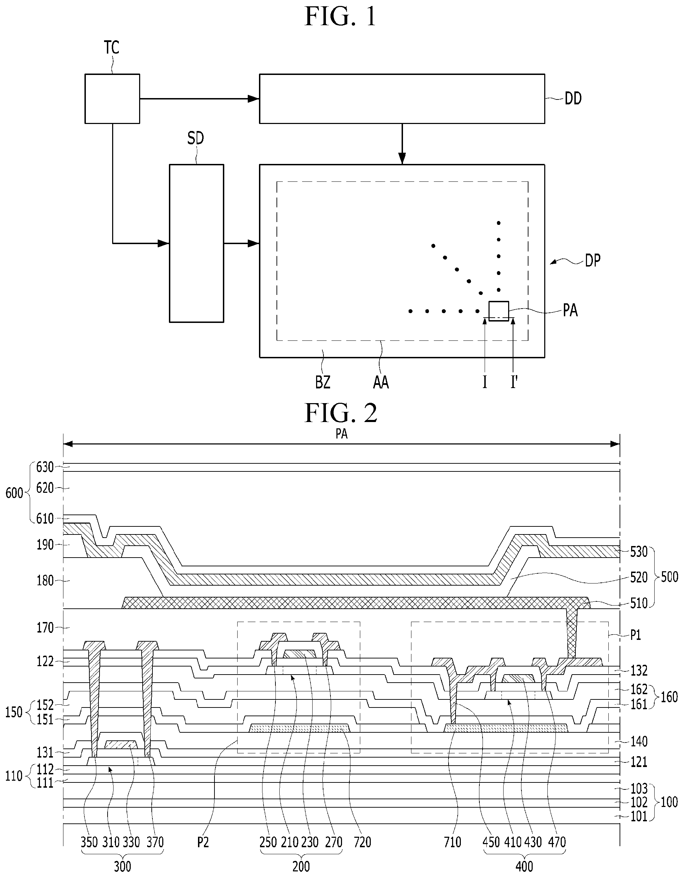

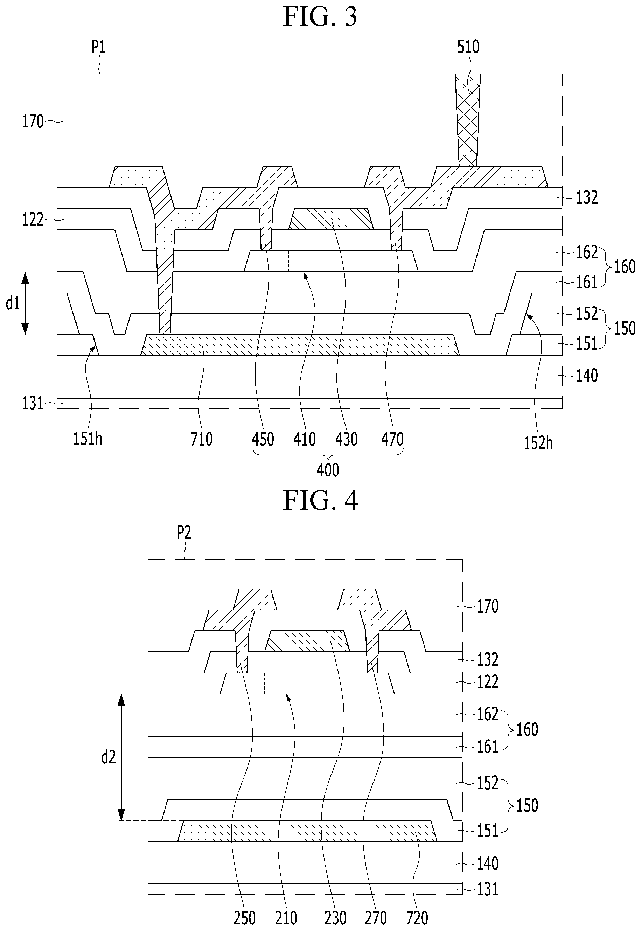

FIG. 1 is a view schematically showing a display apparatus according to an embodiment of the present disclosure. FIG. 2 is a cross-section according to I-I' of FIG. 1 according to an embodiment of the present disclosure. FIG. 3 is an enlarged view of P1 region in FIG. 2 according to an embodiment of the present disclosure. FIG. 4 is an enlarged view of P2 region in FIG. 2 according to an embodiment of the present disclosure.

Referring to FIGS. 1 to 4, the display apparatus according to the embodiment of the present disclosure may include a display panel DP and driving parts SD, DD, and TC. The display panel DP may realize an image being provided to a user. For example, the display panel DP may include a plurality of pixel area PA. The driving parts SD, DD, and TC may provide various signals for realizing the image to each pixel area PA of the display panel DP. For example, the driving parts SD, DD, and TC may include a scan driver SD, a data driver DD and a timing controller TC.

The scan driver SD may sequentially apply a scan signal to each pixel area PA of the display panel DP through scan lines. The data driver DD may apply a data signal to each pixel area PA of the display panel DP through data lines. For example, the display panel DP may include a display area AA in which the pixel areas PA are disposed and a bezel area BZ disposed outside the display area AA, and the scan lines and the data lines may cross the bezel area BZ. The timing controller TC may control the operation of the scan driver SD and the operation of the data driver DD. For example, the timing controller TC may supply clock signals, reset clock signals and start signals to the scan driver SD, and supply a digital video data and a source timing control signal to the data driver DD.

Each of the pixel areas PA in the display panel DP may realize a specific color. For example, a light-emitting device 500 may be disposed in each pixel area PA. The light-emitting device 500 of each pixel area PA may be supported by a device substrate 100. The device substrate 100 may have a multi-layer structure. For example, the device substrate 100 may have a stacked structure of a first substrate layer 101, a substrate insulating layer 102 and a second substrate layer 103. The second substrate layer 103 may include the same material as the first substrate layer 101. For example, the first substrate layer 101 and the second substrate layer 103 may include a polymer material, such as poly-imide (PI). The substrate insulating layer 102 may include an insulating material. For example, the substrate insulating layer 102 may include an inorganic insulating material, such as silicon oxide (SiO) and silicon nitride (SiN). Thus, in the display apparatus according to the embodiment of the present disclosure, the damage of the device substrate 100 and/or the light-emitting device 500 due to external impact and bending may be prevented.

The light-emitting device 500 may emit light displaying a specific color. For example, the light-emitting device 500 may include a first electrode 510, a light-emitting layer 520 and a second electrode 530, which are sequentially stacked on the device substrate 100.

The first electrode 510 may include a conductive material. The first electrode 510 may include a material having a high reflectance. For example, the first electrode 510 may include a metal, such as aluminum (Al) and silver (Ag). The first electrode 510 may have a multi-layer structure. For example, the first electrode 510 may have a structure in which a reflective electrode made of a metal is interposed between transparent electrodes made of transparent conductive material, such as ITO and IZO.

The light-emitting layer 520 may generate light having luminance corresponding to a voltage difference between the first electrode 510 and the second electrode 520. For example, the light-emitting layer 520 may include an emission material layer (EML) having an emission material. The emission material may include an organic material, an inorganic material or a hybrid material. For example, the display panel DP of the display apparatus according to the embodiment of the present disclosure may be an organic light-emitting display apparatus including an organic emission material.

The light-emitting layer 520 may have a multi-layer structure. For example, the light-emitting layer 520 may further include at least one of a hole injection layer (HIL), a hole transport layer (HTL), an electron transport layer (ETL) and an electron injection layer (EIL). Thus, in the display panel DP of the display apparatus according to the embodiment of the present disclosure, the emission efficiency of the light-emitting layer 520 in each pixel area PA may be improved.

The second electrode 530 may include a conductive material. The second electrode 530 may include a material different from the first electrode 510. The transmittance of the second electrode 530 may be higher than the transmittance of the first electrode 510. For example, the second electrode 530 may be a transparent electrode made of a transparent conductive material, such as ITO and IZO. Thus, in the display panel DP of the display apparatus according to the embodiment of the present disclosure, the light generated by the light-emitting layer 520 of each pixel area PA may be emitted to the outside through the second electrode 530 of the corresponding pixel area PA.

A pixel driving circuit being electrically connected to the light-emitting device 500 may be disposed on each pixel area PA of the device substrate 100. For example, the operation of the light-emitting device 500 in each pixel area PA may be controlled by the pixel driving circuit of the corresponding pixel area PA. The pixel driving circuit of each pixel area PA may be electrically connected to the driving parts SD, DD and TC. For example, the pixel driving circuit of each pixel area PA may be electrically connected to one of the scan lines and one of the data lines. The pixel driving circuit of each pixel area PA may supply a driving current corresponding to the data signal to the light-emitting device 500 of the corresponding pixel area PA according to the scan signal. For example, the pixel driving circuit of each pixel area PA may include a first switching thin film transistor 200, a second switching thin film transistor 300 and a driving thin film transistor 400.

The first switching thin film transistor 200 may include a first switching semiconductor pattern 210, a first switching gate electrode 230, a first switching source electrode 250 and a first switching drain electrode 270.

The first switching semiconductor pattern 210 may include a semiconductor material. For example, the first switching semiconductor pattern 210 may include an oxide semiconductor, such as IGZO. The first switching semiconductor pattern 210 may include a first source region, a first channel region and a first drain region. The first channel region may be disposed between the first source region and the first drain region. The first source region and the first drain region may have a resistance lower than the first channel region. For example, the first source region and the first drain region may include a conductorized region of an oxide semiconductor. The first channel region may be a region of an oxide semiconductor, which is not conductorized.

The first switching gate electrode 230 may include a conductive material. For example, the first switching gate electrode 230 may include a metal, such as aluminum (Al), titanium (Ti), copper (Cu), chrome (Cr), molybdenum (Mo) and tungsten (W). The first switching gate electrode 230 may be disposed on the first switching semiconductor pattern 210. The first switching gate electrode 230 may be insulated from the first switching semiconductor pattern 210. For example, an upper gate insulating layer 122 extending between the first switching semiconductor pattern 210 and the first switching gate electrode 230 may be disposed on the device substrate 100. The upper gate insulating layer 122 may include an insulating material. For example, the upper gate insulating layer 122 may include an inorganic insulating material, such as silicon oxide (SiO). The upper gate insulating layer 122 may extend beyond the first switching semiconductor pattern 210. For example, a side of the first switching semiconductor pattern 210 may be covered by the upper gate insulating layer 122.

The first switching gate electrode 230 may overlap the first channel region of the first switching semiconductor pattern 210. For example, the first channel region of the first switching semiconductor pattern 210 may have an electrical conductivity corresponding to a voltage applied to the first switching gate electrode 230.

The first switching source electrode 250 may include a conductive material. For example, the first switching source electrode 250 may include a metal, such as aluminum (Al), titanium (Ti), copper (Cu), chrome (Cr), molybdenum (Mo) and tungsten (W). The first switching source electrode 250 may be insulated from the first switching gate electrode 230. The first switching source electrode 250 may include a material different from the first switching gate electrode 230. The first switching source electrode 250 may be disposed on a layer different from the first switching gate electrode 230. For example, an upper interlayer insulating layer 132 extending between the first switching gate electrode 230 and the first switching source electrode 250 may be disposed on the upper gate insulating layer 122. The upper interlayer insulating layer 132 may include an insulating material. For example, the upper interlayer insulating layer 132 may include an inorganic insulating material, such as silicon oxide (SiO) and silicon nitride (SiN). The upper interlayer insulating layer 132 may extend beyond the first switching semiconductor pattern 210 and the first switching gate electrode 230. For example, a side of the first switching gate electrode 230 may be covered by the upper interlayer insulating layer 132.

The first switching source electrode 250 may be electrically connected to the first source region of the first switching semiconductor pattern 210. For example, a first source contact hole penetrating the upper gate insulating layer 122 and the upper interlayer insulating layer 132 may partially expose the first source region of the first switching semiconductor pattern 210. The first switching source electrode 250 may be in direct contact with the first source region of the first switching semiconductor pattern 210 through the first source contact hole.

The first switching drain electrode 270 may include a conductive material. For example, the first switching drain electrode 270 may include a metal, such as aluminum (Al), titanium (Ti), copper (Cu), chrome (Cr), molybdenum (Mo) and tungsten (W). The first switching drain electrode 270 may be insulated from the first switching gate electrode 230. The first switching drain electrode 270 may include a material different from the first switching gate electrode 230. The first switching drain electrode 270 may be disposed on a layer different from the first switching gate electrode 230. For example, the first switching drain electrode 270 may be disposed on the upper interlayer insulating layer 132. The first switching drain electrode 270 may be disposed on the same layer as the first switching source electrode 250. For example, the first switching drain electrode 270 may include the same material as the first switching source electrode 250.

The first switching drain electrode 270 may be electrically connected to the first drain region of the first switching semiconductor pattern 210. The first switching drain electrode 270 may be spaced away from the first switching source electrode 250. For example, a first drain contact hole penetrating the upper gate insulating layer 122 and the upper interlayer insulating layer 132 may partially expose the first drain region of the first switching semiconductor pattern 210. The first switching drain electrode 270 may be in direct contact with the first drain region of the first switching semiconductor pattern 210.

The second switching thin film transistor 300 may have the same structure as the first switching thin film transistor 200. For example, the second switching thin film transistor 300 may include a second switching semiconductor pattern 310, a second switching gate electrode 330, a second switching source electrode 350 and a second switching drain electrode 370. The second switching thin film transistor 300 may be spaced away from the first switching thin film transistor 200. For example, the second switching semiconductor pattern 310 may be spaced away from the first switching semiconductor pattern 210.

The second switching semiconductor pattern 310 may include a semiconductor material. The second switching semiconductor pattern 310 may include a material different from the first switching semiconductor pattern 210. For example, the second switching semiconductor pattern 310 may include a low-temperature poly-Si (LTPS). The second switching semiconductor pattern 310 may include a second source region, a second channel region and a second drain region. The second channel region may be disposed between the second source region and the second drain region. The second source region and the second drain region may have a resistance lower than the second channel region. For example, the second source region and the second drain region may include conductive impurities.

The second switching semiconductor pattern 310 may be disposed on a layer different from the first switching semiconductor pattern 210. The second switching semiconductor pattern 310 may be disposed closer to the device substrate 100 than the first switching semiconductor pattern 210. For example, a separation insulating layer 140 may be disposed between the device substrate 100 and the upper interlayer insulating layer 132, the first switching semiconductor pattern 210 may be disposed on the separation insulating layer 140, and the second switching semiconductor pattern 310 may be disposed between the device substrate 100 and the separation insulating layer 140. The separation insulating layer 140 may include an insulating material. For example, the separation insulating layer 140 may include an inorganic insulating material, such as silicon oxide (SiO) and silicon nitride (SiN). Thus, in the display apparatus according to the embodiment of the present disclosure, the damage of the first switching semiconductor pattern 210 due to a process of forming the second switching semiconductor pattern 310 may be prevented.

The second switching gate electrode 330 may include a conductive material. For example, the second switching gate electrode 330 may include a metal, such as aluminum (Al), titanium (Ti), copper (Cu), chrome (Cr), molybdenum (Mo) and tungsten (W). The second switching gate electrode 330 may be disposed on the second switching semiconductor pattern 310. The second switching gate electrode 330 may be insulated from the second switching semiconductor pattern 310. The second switching gate electrode 330 may be disposed on a layer different from the first switching gate electrode 230. For example, a lower gate insulating layer 121 covering the second switching semiconductor pattern 310 may be disposed between the device substrate 100 and the separation insulating layer 140, and the second switching gate electrode 330 may be disposed between the lower gate insulating layer 121 and the separation insulating layer 140. The lower gate insulating layer 121 may include an insulating material. For example, the lower gate insulating layer 121 may be an inorganic insulating material, such as silicon oxide (SiO) and silicon nitride (SiN). A side of the second switching semiconductor pattern 310 may be covered by the lower gate insulating layer 121.

The second switching gate electrode 330 may overlap the second channel region of the second switching semiconductor pattern 310. For example, the second channel region of the second switching semiconductor pattern 310 may have an electrical conductivity corresponding to a voltage applied to the second switching gate electrode 330.

The second switching source electrode 350 may include a conductive material. For example, the second switching source electrode 350 may include a metal, such as aluminum (Al), titanium (Ti), copper (Cu), chrome (Cr), molybdenum (Mo) and tungsten (W). The second switching source electrode 350 may be insulated from the second switching gate electrode 330. For example, the second switching source electrode 350 may include a material different from the second switching gate electrode 330. The second source electrode 350 may be disposed on a layer different from the second switching gate electrode 330. For example, a lower interlayer insulating layer 131 covering the second switching gate electrode 330 may be disposed between the lower gate insulating layer 121 and the separation insulating layer 140, and the second switching source electrode 350 may be disposed between the lower interlayer insulating layer 131 and the separation insulating layer 140. The lower interlayer insulating layer 131 may include an insulating material. For example, the lower interlayer insulating layer 131 may be an inorganic insulating material, such as silicon oxide (SiO) and silicon nitride (SiN). A side of the second switching gate electrode 330 may be covered by the lower interlayer insulating layer 131.

The second switching source electrode 350 may be electrically connected to the second source region of the second switching semiconductor pattern 310. For example, a second source contact hole penetrating the lower gate insulating layer 121 and the lower interlayer insulating layer 131 may partially expose the second source region of the second switching semiconductor pattern 310. The second switching source electrode 350 may be in direct contact with the second source region of the second switching semiconductor pattern 310 through the second source contact hole.

The second switching source electrode 350 may be disposed on the same layer as the first switching source electrode 250 and the first switching drain electrode 270. For example, the second switching source electrode 350 may be disposed on the upper interlayer insulating layer 132. The second source contact hole may penetrate the separation insulating layer 140, the upper gate insulating layer 122 and the upper interlayer insulating layer 132. The second switching source electrode 350 may include the same material as the first switching source electrode 250 and the first switching drain electrode 270.

The second switching drain electrode 370 may include a conductive material. For example, the second switching drain electrode 370 may include a metal, such as aluminum (Al), titanium (Ti), copper (Cu), chrome (Cr), molybdenum (Mo) and tungsten (W). The second switching drain electrode 370 may be insulated from the second switching gate electrode 330. For example, the second switching drain electrode 370 may include a material different from the second switching gate electrode 330. The second switching drain electrode 370 may be disposed on a layer different from the second switching gate electrode 330. For example, the lower interlayer insulating layer 131 may extend between the second switching gate electrode 330 and the second switching drain electrode 370.

The second switching drain electrode 370 may be electrically connected to the second drain region of the second switching semiconductor pattern 310. For example, a second drain contact hole penetrating the lower gate insulating layer 121 and the lower interlayer insulating layer 131 may partially expose the second drain region of the second switching semiconductor pattern 310. The second switching drain electrode 370 may be in direct contact with the second drain region of the second switching semiconductor pattern 310 through the second drain contact hole.

The second switching drain electrode 370 may be disposed on the same layer as the second switching source electrode 350. For example, the second switching drain electrode 370 may be disposed on the upper interlayer insulating layer 132. The second drain contact hole may penetrate the separation insulating layer 140, the upper gate insulating layer 122 and the upper interlayer insulating layer 132. The second switching drain electrode 370 may include the same material as the second switching source electrode 350.

The driving thin film transistor 400 may have the same structure of the second switching thin film transistor 300. The driving thin film transistor 400 includes a driving semiconductor pattern 410, a driving gate electrode 430, a driving source electrode 450 and a driving drain electrode 470. The driving thin film transistor 400 may be spaced away from the first switching thin film transistor 200 and the second switching thin film transistor 300. For example, the driving semiconductor pattern 410 may be spaced away from the firs switching semiconductor pattern 210 and the second switching semiconductor pattern 310.

The driving semiconductor pattern 410 may include a semiconductor material. The driving semiconductor pattern 410 may include a material different from the second switching semiconductor pattern 310. For example, the driving semiconductor pattern 410 may include an oxide semiconductor, such as IGZO. The driving semiconductor pattern 410 may include the same material as the first switching semiconductor pattern 210. The driving semiconductor pattern 410 may be disposed on the same layer as the first semiconductor pattern 210. For example, the driving semiconductor pattern 410 may be disposed on the separation insulating layer 140. The driving semiconductor pattern 410 may include a driving source region, a driving channel region and a driving drain region. The driving channel region may be disposed between the driving source region and the driving drain region. The driving source region and the driving drain region may have a resistance lower than the driving channel region. For example, the driving source region and the driving drain region may include a conductorized region of an oxide semiconductor. The driving source region and the driving drain region of the driving semiconductor pattern 410 may have the same resistance as the first source region and the first drain region of the first switching semiconductor pattern 210, respectively. For example, the driving channel region may be a region of an oxide semiconductor, which is not conductorized. The driving channel region of the driving semiconductor pattern 410 may have the same resistance as the first channel region of the first switching semiconductor pattern 210. For example, the driving semiconductor pattern 410 may be formed simultaneously with the first switching semiconductor pattern.

The driving gate electrode 430 may include a conductive material. For example, the driving gate electrode 430 may include a metal, such as aluminum (Al), titanium (Ti), copper (Cu), chrome (Cr), molybdenum (Mo) and tungsten (W). The driving gate electrode 430 may be disposed on the driving semiconductor pattern 410. The driving gate electrode 430 may be insulated from the driving semiconductor pattern 410. For example, the upper gate insulating layer 122 may extend between the driving semiconductor pattern 410 and the driving gate electrode 430. A side of the driving semiconductor pattern 410 may be covered by the upper gate insulating layer 122. The driving gate electrode 430 may include the same material as the first gate electrode 230 of the first thin film transistor 200.

The driving gate electrode 430 may overlap the driving channel region of the driving semiconductor pattern 410. For example, the driving channel region of the driving semiconductor pattern 410 may have an electrical conductivity corresponding to a voltage applied to the driving gate electrode 430.

The driving source electrode 450 may include a conductive material. For example, the driving source electrode 450 may include a metal, such as aluminum (Al), titanium (Ti), copper (Cu), chrome (Cr), molybdenum (Mo) and tungsten (W). The driving source electrode 450 may be insulated from the driving gate electrode 430. For example, driving source electrode 450 may include a material different from the driving gate electrode 430. The driving source electrode 450 may be disposed on a layer different from the driving gate electrode 430. For example, the upper interlayer insulating layer 132 may extend between the driving gate electrode 430 and the driving source electrode 450. The driving source electrode 450 may include the same material as the first source electrode 250 and the first drain electrode 270. For example, the driving source electrode 450 may be disposed on the same layer as the first source electrode 250 and the first drain electrode 270.

The driving source electrode 450 may be electrically connected to the driving source region of the driving semiconductor pattern 410. For example, a third source contact hole penetrating the upper gate insulating layer 122 and the upper interlayer insulating layer 132 may partially expose the driving source region of the driving semiconductor pattern 410. The driving source electrode 450 may be in direct contact with the driving source region of the driving semiconductor pattern 310 through the third source contact hole.

The driving drain electrode 470 may include a conductive material. For example, the driving drain electrode 470 may include a metal, such as aluminum (Al), titanium (Ti), copper (Cu), chrome (Cr), molybdenum (Mo) and tungsten (W). The driving drain electrode 470 may be insulated from the driving gate electrode 430. For example, the driving drain electrode 470 may include a material different from the driving gate electrode 430. The driving drain electrode 470 may be disposed on a layer different from the driving gate electrode 430. For example, the upper interlayer insulating layer 132 may extend between the driving gate electrode 430 and the driving drain electrode 470. The driving drain electrode 470 may be disposed on the same layer as the driving source electrode 450. For example, the driving drain electrode 470 may include the same material as the driving source electrode 450.

The driving drain electrode 470 may be electrically connected to the driving drain region of the driving semiconductor pattern 410. For example, a third drain contact hole penetrating the upper gate insulating layer 122 and the upper interlayer insulating layer 132 may partially expose the driving drain region of the driving semiconductor pattern 410. The driving drain electrode 470 may be in direct contact with the driving drain region of the driving semiconductor pattern 410 through the third drain contact hole.

The scan lines and the data lines may be formed by a process of forming the first switching thin film transistor 200, the second switching thin film transistor 300 and the driving thin film transistor 400 in each pixel area PA. For example, the scan lines may be disposed on the same layer as the second switching gate electrode 330 of each pixel driving circuit, and the data lines may be disposed on the same layer as the first switching source electrode 250 and the first switching drain electrode 270 of each pixel driving circuit. The scan lines may include the same material as the second switching gate electrode 330 of each pixel driving circuit. For example, the scan lines may be disposed between the lower gate insulating layer 121 and the lower interlayer insulating layer 131. The data lines may include the same material as the first switching source electrode 250, the first switching drain electrode 270, the second switching source electrode 350, the second switching drain electrode 370, the driving source electrode 450 and the driving drain electrode 470 of each pixel driving circuit. For example, the data lines may be disposed on the upper interlayer insulating layer 132.

A lower buffer layer 110 may be disposed between the device substrate 100 and each pixel driving circuit. The lower buffer layer 110 may prevent pollution due to the device substrate 100 in a process of forming each pixel driving circuit. For example, an upper surface of the device substrate 100 toward the first switching thin film transistor 200, the second switching thin film transistor 300 and the driving thin film transistor 400 of each pixel driving circuit may be completely covered by the lower buffer layer 110. The lower buffer layer 110 may include an insulating material. For example, the lower buffer layer 110 may include an inorganic insulating material, such as silicon oxide (SiO) and silicon nitride (SiN). The lower buffer layer 110 may have a multi-layer structure. For example, the lower buffer layer 110 may have a stacked structure of a first lower layer 111 and a second lower layer 112. The second lower layer 112 may include a material different from the first lower layer 111. For example, the lower buffer layer 110 may have a stacked structure of an inorganic insulating layer made of silicon oxide (SiO) and an inorganic insulating layer made of silicon nitride (SiN).

The light-emitting device 500 of each pixel area PA may be electrically connected to the driving thin film transistor 400 of the pixel driving circuit in the corresponding pixel area PA. For example, the first electrode 510 of the light-emitting device 500 in each pixel area PA may be electrically connected to the driving drain electrode 470 of the driving thin film transistor 400 in the corresponding pixel area PA. The first electrode 510 of the light-emitting device 500 in each pixel area PA may be insulated from the first switching source electrode 250, the first switching drain electrode 270, the second switching source electrode 350, the second switching drain electrode 370 and the driving source electrode 450 in the corresponding pixel area PA. The first electrode 510 of each pixel area PA may be disposed on a layer different from the first switching source electrode 250, the first switching drain electrode 270, the second switching source electrode 350, the second switching drain electrode 370, the driving source electrode 450 and the driving drain electrode 470 of the corresponding pixel area PA. For example, an over-coat layer 170 covering the first switching source electrode 250, the first switching drain electrode 270, the second switching source electrode 350, the second switching drain electrode 370, the driving source electrode 450 and the driving drain electrode 470 may be disposed on the upper interlayer insulating layer 132, and the first electrode 510, the light-emitting layer 520 and the second electrode 530 of each pixel area PA may be stacked on the over-coat layer 170. The over-coat layer 170 may include an insulating material. The over-coat layer 170 may include a material different from the upper interlayer insulating layer 132. For example, the over-coat layer 170 may be an organic insulating material. A thickness difference due to the pixel driving circuit of each pixel area PA may be removed by the over-coat layer 170. For example, the over-coat layer 170 may remove a thickness difference due to the first switching thin film transistor 200, the second switching thin film transistor 300 and the driving thin film transistor 400 of each pixel area PA. An upper surface of the over-coat layer 170 opposite to the device substrate 100 may be a flat surface.

The first electrode 510 of each pixel area PA may be electrically connected to the driving drain electrode 470 of the corresponding pixel area PA by penetrating the over-coat layer 170. For example, the over-coat layer 170 may include electrode contact holes partially exposing the driving drain electrode 470 of each pixel area PA. The first electrode 510 of each pixel area PA may be in direct contact with the driving drain electrode 470 of the corresponding pixel area PA through one of the electrode contact holes.

The light-emitting device 500 of each pixel area PA may emit light having luminance different from the light-emitting device 500 of adjacent pixel area PA. For example, the first electrode 510 of the light-emitting device 500 in each pixel area PA may be spaced away from the first electrode 510 of the light-emitting device 500 in adjacent pixel area PA. The first electrode 510 of the light-emitting device 500 in each pixel area PA may be insulated from the first electrode 510 of the light-emitting device 500 in adjacent pixel area PA. For example, a bank insulating layer 180 may be disposed on the over-coat layer 170, and an edge of the first electrodes 510 in each pixel area PA may be covered by the bank insulating layer 180. The bank insulating layer 180 may include an insulating material. For example, the bank insulating layer 180 may be an organic insulating material. The bank insulating layer 180 may include a material different from the over-coat layer 170. The light-emitting layer 520 and the second electrode 530 of each pixel area PA may be sequentially stacked on a portion of the corresponding first electrode 510 exposed by the bank insulating layer 180.

The light emitted from the light-emitting device 500 of each pixel area PA may display a color different from the light emitted from the light-emitting device 500 of adjacent pixel area PA. For example, the light-emitting layer 520 of each pixel area PA may be spaced away from the light-emitting layer 520 of adjacent pixel area PA. The light-emitting layer 520 in each pixel area PA may include an end disposed on the bank insulating layer 180. The light-emitting layer 520 of each pixel area PA may be formed individually. For example, the light-emitting layer 520 of each pixel area PA may be formed using a fine metal mask (FMM). A spacer 190 may be disposed on the bank insulating layer 180. The spacer 190 may prevent the damage of the bank insulating layer 180 and the light-emitting layer 520 due to the fine metal mask. The spacer 190 may include an insulating material. For example, the spacer 190 may be an organic insulating material. The spacer 190 may include the same material as the bank insulating layer 180. For example, the bank insulating layer 180 and the spacer 190 may be formed simultaneously by a patterning process using a half-tone mask. The end of the light-emitting layer 520 in each pixel area PA may be spaced away from the spacer 190.

A voltage applied to the second electrode 530 of each pixel area PA may be the same as a voltage applied to the second electrode 530 of adjacent pixel area PA. For example, the second electrode 530 of each pixel area PA may be electrically connected to the second electrode 530 of adjacent pixel area PA. The second electrode 530 of each pixel area PA may include the same material as the second electrode 530 of adjacent pixel area PA. For example, the second electrode 530 of each pixel area PA may be in direct contact with the second electrode 530 of adjacent pixel area PA. The bank insulating layer 180 and the spacer 190 may be covered by the second electrode 530. Thus, in the display apparatus according to the embodiment of the present disclosure, the luminance of the light emitted from the light-emitting device 500 of each pixel area PA may be controlled by the driving current generated by the pixel driving circuit of the corresponding pixel area PA. And, in the display apparatus according to the embodiment of the present disclosure, a process of forming the second electrode 530 of each pixel area PA may be simplified.

An encapsulating element 600 may be disposed on the light-emitting device 500 of each pixel area PA. The encapsulating element 600 may prevent the damage of the light-emitting devices 500 due to external impact and moisture. The encapsulating element 600 may have a multi-layer structure. For example, the encapsulating element 600 may include a first encapsulating layer 610, a second encapsulating layer 620 and a third encapsulating layer 630, which are sequentially stacked. The first encapsulating layer 610, the second encapsulating layer 620 and the third encapsulating layer 630 may include an insulating material. The second encapsulating layer 620 may include a material different from the first encapsulating layer 610 and the third encapsulating layer 630. For example, the first encapsulating layer 610 and the third encapsulating layer 630 may be an inorganic insulating material, and the second encapsulating layer 620 may be an organic insulating material. Thus, in the display apparatus according to the embodiment of the present disclosure, the damage of the light-emitting device 500 in each pixel area PA due to the external impact and moisture may be effectively prevented. A thickness difference by the light-emitting device 500 of each pixel area PA may be removed by the second encapsulating layer 620. For example, an upper surface of the encapsulating element 600 opposite to the device substrate 100 may be a flat surface.

The display apparatus according to the embodiment of the present disclosure may prevent a change in characteristics of the semiconductor patterns 210 and 410 including an oxide semiconductor due to external light. Light-blocking patterns 710 and 720 are disposed in each pixel area PA. The light-blocking pattern 710 and 720 may block the external light travelling in a direction of the semiconductor patterns 210 and 410 including an oxide semiconductor. The light-blocking patterns 710 and 720 of each pixel area PA include a first light-blocking pattern 710 between the device substrate 100 and the driving semiconductor pattern 410, and a second light-blocking pattern 720 between the device substrate 100 and the first switching semiconductor pattern 210.

The first light-blocking pattern 710 may block the external light travelling in a direction of the driving semiconductor pattern 410 passing through the device substrate 100. The first light-blocking pattern 710 is disposed between the device substrate 100 and the driving semiconductor pattern 410. For example, the first light-blocking pattern 710 may be disposed between the separation insulating layer 140 and the driving semiconductor pattern 410. The first light-blocking pattern 710 may have a size larger than the driving semiconductor pattern 410. The driving semiconductor pattern 410 overlaps a portion of the first light-blocking pattern 710. The first light-blocking pattern 710 may be spaced away from the first switching thin film transistor 200 and the second switching thin film transistor 300. For example, the first switching thin film transistor 200 and the second switching thin film transistor 300 may be disposed at the outside of the first light-blocking pattern 710.

The first light-blocking pattern 710 may include a conductive material. For example, the first light-blocking pattern 710 may include a metal. The first light-blocking pattern 710 may include a material capable of blocking the penetration of hydrogen. The first light-blocking pattern 710 may include a material stably coupling with hydrogen. For example, the first light-blocking pattern 710 may include titanium (Ti). Thus, in the display apparatus according to the embodiment of the present disclosure, hydrogen remaining between the device substrate 100 and the separation insulating layer 140 due to a process of forming the second switching semiconductor pattern 310 and the second switching gate electrode 330 may not penetrate in the driving semiconductor pattern 410 by the first light-blocking pattern 710. That is, in the display apparatus according to the embodiment of the present disclosure, the unintended conductorization of the driving semiconductor pattern 410 in each pixel area PA may be prevented by the first light-blocking pattern 710. Therefore, in the display apparatus according to the embodiment of the present disclosure, the reliability for the operating characteristics of the driving thin film transistor 400 in each pixel area PA may be improved.

The first light-blocking pattern 710 may be spaced away from the driving semiconductor pattern 410. For example, an upper buffer layer 160 covering the first light-blocking pattern 710 may be disposed on the separation insulating layer 140, and the driving semiconductor pattern 410 may be disposed on the upper buffer layer 160. The upper buffer layer 160 may prevent pollution due to the first light-blocking pattern 710 in a process of forming the driving semiconductor pattern 410 in each pixel area PA. The upper buffer layer 160 may include an insulating material. For example, the upper buffer layer 160 may include an inorganic insulating material, such as silicon oxide (SiO) and silicon nitride (SiN). The upper buffer layer 160 may have a multi-layer structure. For example, the upper buffer layer 160 may have a stacked structure of a first upper layer 161 and a second upper layer 162. The second upper layer 162 may include a material different from the first upper layer 161. For example, the first upper layer 161 may be an inorganic insulating layer made of silicon nitride (SiN), and the second upper layer 162 disposed on the first upper layer 161 may be an inorganic insulating layer made of silicon oxide (SiO). The inorganic insulating layer made of silicon nitride (SiN) has better ability to trap hydrogen particles than the inorganic insulating layer made of silicon oxide (SiO). Thus, in the display apparatus according to the embodiment of the present disclosure, the first upper layer 161 may prevent hydrogen remaining between the device substrate 100 and the upper buffer layer 160 from penetrating the driving semiconductor pattern 410, and the second upper layer 162 may prevent the unintended conductorization of the driving semiconductor pattern 410 in each pixel area PA by hydrogen trapped in the first upper layer 161.

The second light-blocking pattern 720 may block the external light travelling in a direction of the first switching semiconductor pattern 210 passing through the device substrate 100. The second light-blocking pattern 720 may be disposed between the device substrate 100 and the first switching semiconductor pattern 210. For example, the second light-blocking pattern 720 may be disposed between the separation insulating layer 140 and the first switching semiconductor pattern 210. The second light-blocking pattern 720 may be disposed on the same layer as the first light-blocking pattern 710. The second light-blocking pattern 720 may have a size larger than the first switching semiconductor pattern 210. For example, the first switching semiconductor pattern 210 may overlap a portion of the second light-blocking pattern 720. The second light-blocking pattern 720 may be spaced away from the second switching thin film transistor 300 and the driving thin film transistor 400. For example, the second switching thin film transistor 300 and the driving thin film transistor 400 may be disposed at the outside of the second light-blocking pattern 720.

The second light-blocking pattern 720 may include a conductive material. For example, the second light-blocking pattern 720 may include a metal. The second light-blocking pattern 720 may include a material capable of blocking the penetration of hydrogen. The second light-blocking pattern 720 may include a material stably coupling with hydrogen. The second light-blocking pattern 720 may include the same material as the first light-blocking pattern 710. For example, the second light-blocking pattern 720 may include titanium (Ti). The second light-blocking pattern 720 may be formed simultaneously with the first light-blocking pattern 710. Thus, in the display apparatus according to the embodiment of the present disclosure, hydrogen remaining between the device substrate 100 and the separation insulating layer 140 due to a process of forming the second switching semiconductor pattern 310 and the second switching gate electrode 330 may not penetrate in the first switching semiconductor pattern 210 by the second light-blocking pattern 720. That is, in the display apparatus according to the embodiment of the present disclosure, the unintended conductorization of the first switching semiconductor pattern 210 in each pixel area PA may be prevented by the second light-blocking pattern 720. Therefore, in the display panel DP of the display apparatus according to the embodiment of the present disclosure, the reliability for the operating characteristics of the first switching thin film transistor 200 in each pixel area PA may be improved.

The second light-blocking pattern 720 may be insulated from the second switching semiconductor pattern 210. For example, the upper buffer layer 160 may extend between the second light-blocking pattern 720 and the first switching semiconductor pattern 210.

The second light-blocking pattern 720 may be insulated from the first switching semiconductor pattern 210. For example, the first upper layer 161 and the second upper layer 162 of the upper buffer layer 160 may extend between the second light-blocking pattern 720 and the first switching semiconductor pattern 210. For example, the driving semiconductor pattern 410 and the first switching semiconductor pattern 210 may be disposed on the same upper buffer layer 160. Thus, in the display apparatus according to the present disclosure, changing characteristics of the first switching semiconductor pattern 210 due to the remaining hydrogen may be prevented by the upper buffer layer 160.

A first straight distance d1 between the first light-blocking pattern 710 and the driving semiconductor pattern 410 may be smaller than a second straight distance d2 between the second light-blocking pattern 720 and the first switching semiconductor pattern 210. For example, one or more insulating layers (e.g., upper buffer layer 160) may be disposed on the first light-blocking pattern 710 and the second light-blocking pattern 720, and a first distance d1 may be shorter than a second distance d2, where at least a portion of the intermediate insulating layer 150 is disposed between the second light-blocking pattern 720 and the first switching semiconductor pattern 210. For example, an intermediate insulating layer 150 covering the second light-blocking pattern 720 may be disposed between the separation insulating layer 140 and the upper buffer layer 160, and the intermediate insulating layer 150 includes an opening 151h and 152h overlapping with the first light-blocking pattern 710 and the driving semiconductor pattern 410. Therefore, a side surface of the intermediate insulating layer 150 exposed by the opening 151h and 152h may be created, and the side surface of the intermediate insulating layer 150 may be located between the first light-blocking pattern 710 and the second light-blocking pattern 720. The intermediate insulating layer 150 may include an insulating material. For example, the intermediate insulating layer 150 may include an inorganic insulating material, such as silicon oxide (SiO) and silicon nitride (SiN). The intermediate insulating layer 150 may have a multi-layer structure. For example, the intermediate insulating layer 150 may include a stacked structure of a first intermediate insulating layer 151 (henceforth referred to as "first intermediate layer 151") and a second intermediate insulating layer 152 (henceforth referred to as "second intermediate layer 152"). The second intermediate layer 152 may include a material different from the first intermediate layer 151. For example, the first intermediate layer 151 may be an inorganic insulating layer made of silicon nitride (SiN), and the second intermediate layer 152 on the first intermediate layer 151 may be an inorganic insulating layer made of silicon oxide (SiO). The opening 151h and 152h may include a first opening 151h penetrating the first intermediate layer 151 and a second opening 152h penetrating the second intermediate layer 152. The opening 151h and 152h has a size larger than the first light-blocking pattern 710 and the driving semiconductor pattern 410. For example, the first light-blocking pattern 710 may be disposed in the first opening 151h of the opening 151h and 152h. A side of the first light-blocking pattern 710 may be covered by the first upper layer 161. An upper surface of the first light-blocking pattern 710 opposite to the device substrate 100 may be in direct contact with the first upper layer 161. Thus, in the display apparatus according to the embodiment of the present disclosure, regardless of the second straight distance d2 between the second light-blocking pattern 720 and the first switching semiconductor pattern 210 in each pixel area PA, only the first straight distance d1 between the first light-blocking pattern 710 and the driving semiconductor pattern 410 in each pixel area PA may be reduced.

A specific voltage may be applied to the first light-blocking pattern 710. For example, the first light-blocking pattern 710 may be electrically connected to the driving source electrode 450. A constant voltage may be applied to the first light-blocking pattern 710, regardless of a voltage applied to the driving gate electrode 430. Thus, in the display apparatus according to the embodiment of the present disclosure, a first parasitic capacitor may be formed between the first light-blocking pattern 710 and the driving semiconductor pattern 410 in each pixel area PA. That is, in the display apparatus according to the embodiment of the present disclosure, the amount of change in the effective gate voltage that affects the driving current applied to the light-emitting device 500 in the pixel area PA may be determined by the following equation. Herein, $\Delta V_{eff}$ denotes the amount of change in the effective gate voltage, C1 denotes a capacitance of the first parasitic capacitor between the first light-blocking pattern 710 and the driving semiconductor pattern 410 in each pixel area PA, C2 denotes a capacitance of a second parasitic capacitor between the driving semiconductor pattern 410 and the driving gate electrode 430 in each pixel area PA, $C_{ACT}$ denotes a capacitance of a parasitic capacitor formed inside the driving semiconductor pattern 410 by a voltage applied to the driving source region and the driving drain region of the driving semiconductor pattern 410, and $\Delta V_{GAT}$ denotes a change amount of a voltage applied to the driving gate electrode 430.

[equation 1]

$$\Delta V_{eff} = \frac{C2}{C2 + C_{ACT} + C1} \times \Delta V_{GAT}$$

Referring to the equation, when the capacitance of the first parasitic capacitor formed between the first light-blocking pattern 710 and the driving semiconductor pattern 410 may be increased, a ratio of the capacitance of the second parasitic capacitor to the capacitance of the first parasitic capacitor is reduced, such that the amount of change in the effective gate voltage may be reduced. For example, when the capacitance of the first parasitic capacitor is larger than the capacitance of the second parasitic capacitor, the effective gate voltage that affects the generation of the driving current may be very small. In generally, when the effective gate voltage of a thin film transistor is reduced, S-factor may be increased and a rate of change in the current according to the applied voltage may be decreased. That is, when a ratio of the capacitance of the second parasitic capacitor to the capacitance of the first parasitic capacitor is reduced, S-factor of the driving thin film transistor 400 may be increased and the occurrence of a spot in low grayscale where the current must be precisely controlled may be prevented. Thus, in the display apparatus according to the embodiment of the present disclosure in which the first straight distance d1 between the first light-blocking pattern 710 and the driving semiconductor pattern 410 is reduced by the opening 151h and 152h of the intermediate insulating layer 150, the capacitance of the first parasitic capacitor may be increased, a ratio of the capacitance of the second parasitic capacitor to the capacitance of the first parasitic capacitor may be reduced, the effective gate voltage of the driving thin film transistor 400 may be reduced, S-factor of the driving thin film transistor 400 may be increased, and a rate of change in the driving current according to the voltage applied to the driving gate electrode 430 of the driving thin film transistor 400 may be decreased. And, in the display apparatus according to the embodiment of the present disclosure, the second straight distance d2 between the second light-blocking pattern 720 and the first semiconductor pattern 210 may be not changed by the opening 151h and 152h of the intermediate insulating layer 150. Therefore, in the display apparatus according to the embodiment of the present disclosure, the occurrence of the spot in low grayscale may be prevented, without changing the characteristics of the first switching thin film transistor 200 and the second switching thin film transistor 300 in each pixel area PA.

Accordingly, the display apparatus according to the embodiment of the present disclosure may include the first switching thin film transistor 200, the second switching thin film transistor 300, the driving thin film transistor 400, the first light-blocking pattern 710 and the second light-blocking pattern 720, which are disposed in each pixel area PA of the display panel DP, wherein the first light-blocking pattern 710 and the second light-blocking pattern 720 may be disposed on the separation insulating layer 140, wherein the first switching thin film transistor 200 and the driving thin film transistor 400 may be disposed on the upper buffer layer 160 covering the first light-blocking pattern 710 and the second light-blocking pattern 720, and wherein the intermediate insulating layer 150 between the second light-blocking pattern 720 and the upper buffer layer 160 includes the opening 151h and 152h overlapping with the driving semiconductor pattern 410 and the first light-blocking pattern 710. Thus, in the display apparatus according to the embodiment of the present disclosure, characteristics of the driving thin film transistor 400 in each pixel area PA may be controlled, without changing the structure of the first switching thin film transistor 200 and the second switching thin film transistor 300 in each pixel area PA. That is, in the display apparatus according to the embodiment of the present disclosure, the occurrence of the spot in low grayscale may effectively prevented, without changing the characteristics of the first switching thin film transistor 200 and the second switching thin film transistor 300. Therefore, in the display apparatus according to the embodiment of the present disclosure, the quality of the image provided to the user may be improved.

And, in the display apparatus according to the embodiment of the present disclosure, the first light-blocking pattern 710 may have the size larger than the driving semiconductor pattern 410, and the second light-blocking pattern 720 may have the size larger than the first switching semiconductor pattern 210. Thus, in the display apparatus according to the embodiment of the present disclosure, a change in the characteristics of the first switching semiconductor pattern 210 and/or the driving semiconductor pattern 410 due to light diffracted from an end of the first light-blocking pattern 710 and an end of the second light-blocking pattern 720 may be reduced or minimized. Therefore, in the display apparatus according to the embodiment of the present disclosure, the deterioration of the image due to the external light may be prevented.

In the display apparatus according to another embodiment of the present disclosure, a specific voltage may be applied to the second light-blocking pattern 720. For example, a voltage applied to the second light-blocking pattern 720 may be the same as a voltage applied to the first switching gate electrode 230. The second light-blocking pattern 720 may be electrically connected to the first switching gate electrode 230. Thus, in the display apparatus according to another embodiment of the present disclosure, the second light-blocking pattern 720 in each pixel area PA may serve as a gate electrode of the first switching thin film transistor 200 in the corresponding pixel area PA. That is, in the display apparatus according to another embodiment of the present disclosure, the first channel region of the first semiconductor pattern 210 in each pixel area PA may have an electrical conductivity corresponding to a voltage applied to the first switching gate electrode 230 in the corresponding pixel area PA and a voltage applied to the second light-blocking pattern 720 in the corresponding pixel area PA. Therefore, in the display apparatus according to another embodiment of the present disclosure, the operating characteristics of the first switching thin film transistor 200 in each pixel area PA may be improved. For example, in the display apparatus according to another embodiment of the present disclosure, the first switching thin film transistor 200 in each pixel area PA may be turned on, quickly.

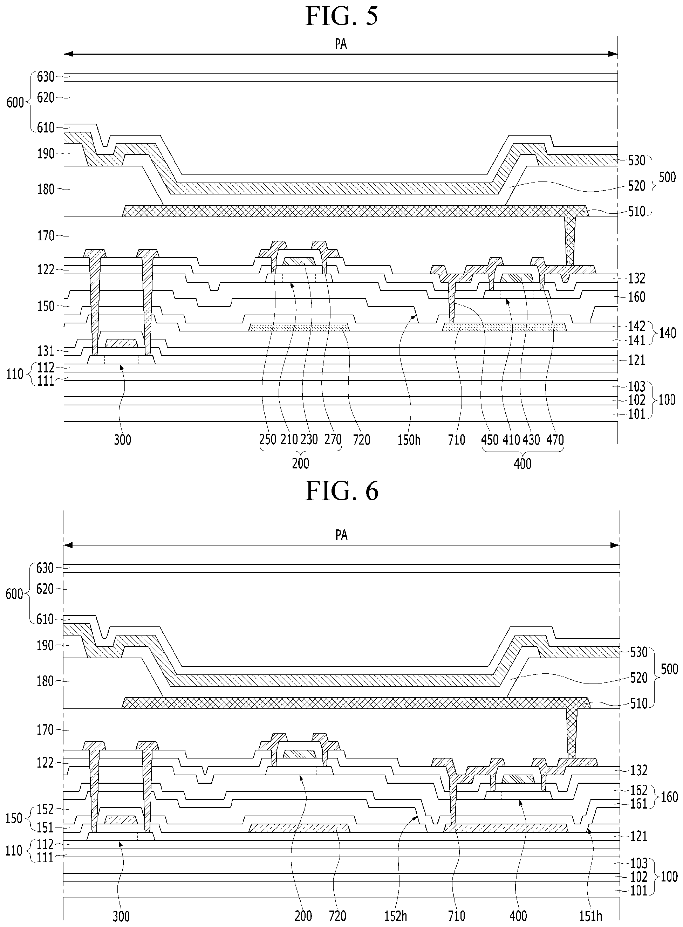

The display apparatus according to the embodiment of the present disclosure is described that the intermediate insulating layer 150 and the upper buffer layer 160 have a two-layer structure, respectively. However, in the display apparatus according to another embodiment of the present disclosure, each of the intermediate insulating layer 150 and the upper buffer layer 160 may have a single-layer structure, as shown in FIG. 5. For example, the opening 150h penetrating the intermediate insulating layer 150 may be disposed between the first light-blocking pattern 710 and the driving semiconductor pattern 410.

In the display apparatus according to another embodiment of the present disclosure, the separation insulating layer 140 may have a multi-layer structure. For example, the separation insulating layer 140 may have a stacked structure of a first separating layer 141 and a second separating layer 142. The second separating layer 142 may include a material different from the first separating layer 141. For example, the first separating layer 141 may be an inorganic insulating layer made of silicon oxide (SiO), and the second separating layer 142 may be an inorganic insulating layer made of silicon nitride (SiN).

The first light-blocking pattern 710 and the second light-blocking pattern 720 may be disposed in the separation insulating layer 140. For example, the first light-blocking pattern 710 and the second light-blocking pattern 720 may be disposed between the first separating layer 141 and the second separating layer 142. The upper surface and the side of the first light-blocking pattern 710 may be covered by the second separating layer 142. The opening 150h of the intermediate insulating layer 150 may be filled with the upper buffer layer 160. Thus, in the display apparatus according to another embodiment of the present disclosure, the degree of freedom for a material and a structure of the separation insulating layer 140, the intermediate insulating layer 150 and the upper buffer layer 160 may be improved.

The display apparatus according to the embodiment of the present disclosure is described that the first light-blocking pattern 710 and the second light-blocking pattern 720 are disposed on the separation insulating layer 140. However, in the display apparatus according to another embodiment of the present disclosure, the number of insulating layers stacked between the device substrate 100 and the light-emitting device 500 of each pixel area PA may be reduced or minimized. For example, in the display apparatus according to another embodiment of the present disclosure, the first light-blocking pattern 710 and the second light-blocking pattern 720 may be disposed on the same layer as the second switching gate electrode of the second switching thin film transistor 300, as shown in FIG. 6. For example, the first light-blocking pattern 710 and the second light-blocking pattern 720 may be disposed on the lower gate insulating layer 121. The first light-blocking pattern 710 and the second light-blocking pattern 720 may include the same material as the second switching gate electrode of the second switching thin film transistor 300. The second switching gate electrode of the second switching thin film transistor 300 may be covered by the intermediate insulating layer 150. For example, the second switching gate electrode of the second switching thin film transistor 300 may be in direct contact with the first intermediate layer 151. Thus, in the display apparatus according to another embodiment of the present disclosure, the occurrence of the spot in low grayscale may be prevented, regardless of the number of the insulating layers stacked between the device substrate 100 and the light-emitting device 500 of each pixel area PA.

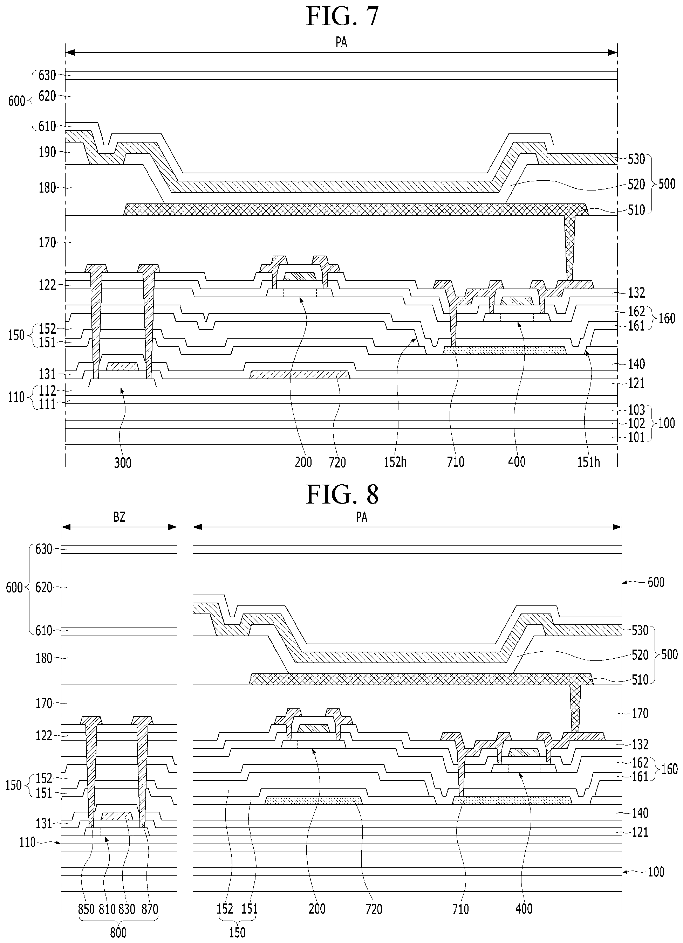

The display apparatus according to the embodiment of the present disclosure is described that the second light-blocking pattern 720 is disposed on the same layer as the first light-blocking pattern 710. However, in the display apparatus according to another embodiment of the present disclosure, the second light-blocking pattern 720 may be disposed on a layer different from the first light-blocking pattern 710. For example, in the display apparatus according to another embodiment of the present disclosure, the first light-blocking pattern 710 may be disposed in the opening 151h and 152h of the intermediate insulating layer 150, and the second light-blocking pattern 720 may be disposed between the lower gate insulating layer 121 and the lower interlayer insulating layer 131, as shown in FIG. 7. For example, the second light-blocking pattern 720 may be disposed on the same layer as the second switching gate electrode of the second switching thin film transistor 300. The second light-blocking pattern 720 may include a material different from the first light-blocking pattern 710. For example, the second light-blocking pattern 720 may include the same material as the second switching gate electrode of the second switching thin film transistor 300. Thus, in the display apparatus according to another embodiment of the present disclosure, the capacitance of the parasitic capacitor formed between the first light-blocking pattern 710 and the driving semiconductor pattern of the driving thin film transistor 400 may be increased or maximized, without changing the structure of the first switching thin film transistor 200. Therefore, in the display apparatus according to another embodiment of the present disclosure, the effective gate voltage of the driving thin film transistor 400 in each pixel area PA may be reduced or minimized, and the occurrence of the spot in low grayscale may be effectively prevented.

The display apparatus according to the embodiment of the present disclosure is described that the pixel driving circuit of each pixel area PA includes the second switching thin film transistor 300 including the second switching semiconductor pattern 310 made of low-temperature poly-Si (LPTS). However, in the display apparatus according to another embodiment of the present disclosure, the pixel driving circuit of each pixel area PA may be constituted of only thin film transistors including a semiconductor pattern made of an oxide semiconductor. For example, in the display apparatus according to another embodiment of the present disclosure, only the first switching thin film transistor 200 and the driving thin film transistor 400 including a semiconductor pattern made of an oxide semiconductor may be disposed in each pixel area PA, as shown in FIG. 8.

In the display apparatus according to another embodiment of the present disclosure, at least one of the driving parts SD, DD and TC may be disposed on the bezel area BZ of the device substrate 100. For example, the display panel DP of the display apparatus according to another embodiment of the present disclosure may include at least one controlling thin film transistor 800 on the bezel area BZ of the device substrate 100. The controlling thin film transistor 800 may have the same structure as the first switching thin film transistor 200. For example, the controlling thin film transistor may include a controlling semiconductor pattern 810, a controlling gate electrode 830, a controlling source electrode 850 and a controlling drain electrode 870.

The controlling semiconductor pattern 810 may include a semiconductor material. The controlling semiconductor pattern 810 may include a material different from the first switching semiconductor pattern of the first switching thin film transistor 200. For example, the controlling semiconductor pattern 810 may include a low-temperature poly-Si (LTPS). The controlling semiconductor pattern 810 may include a control source region, a control channel region and a control drain region. The control channel region may be disposed between the control source region and the control drain region. The control source region and the control drain region may have a resistance lower than the control channel region. For example, the control source region and the control drain region may include conductive impurities.

The controlling semiconductor pattern 810 may be disposed on a layer different from the first switching semiconductor pattern of the first switching thin film transistor. For example, the controlling semiconductor pattern 810 may be disposed between the lower buffer layer 110 and the lower gate insulating layer 121. Thus, in the display apparatus according to another embodiment of the present disclosure, changing the characteristics of the first switching thin film transistor 200 and the driving thin film transistor 400 due to a process of forming the controlling semiconductor pattern 810 may be prevented.

The controlling gate electrode 830 may include a conductive material. For example, the controlling gate electrode 830 may include a metal, such as aluminum (Al), titanium (Ti), copper (Cu), chrome (Cr), molybdenum (Mo) and tungsten (W). The controlling gate electrode 830 may be disposed on the controlling semiconductor pattern 810. The controlling gate electrode 830 may be insulated from the controlling semiconductor pattern 810. The controlling gate electrode 830 may be disposed on a layer different from the first switching gate electrode of the first switching thin film transistor 200. For example, the controlling gate electrode 830 may be disposed between the lower gate insulating layer 121 and the lower interlayer insulating layer 131. The controlling gate electrode 830 may overlap the control channel region of the controlling semiconductor pattern 810. For example, the control channel region of the controlling semiconductor pattern 810 may have an electrical conductivity corresponding to a voltage applied to the controlling gate electrode 830.

The controlling source electrode 850 may include a conductive material. For example, the controlling source electrode 850 may include a metal, such as aluminum (Al), titanium (Ti), copper (Cu), chrome (Cr), molybdenum (Mo) and tungsten (W). The controlling source electrode 850 may be insulated from the controlling gate electrode 830. For example, the controlling source electrode 850 may include a material different from the controlling gate electrode 830. The second source electrode 850 may be disposed on a layer different from the second gate electrode 830. For example, the controlling source electrode 850 may be disposed the upper interlayer insulating layer 132. The controlling source electrode 850 may include the same material as the first switching source electrode and the first switching drain electrode of the first switching thin film transistor 200.

The controlling source electrode 850 may be electrically connected to the control source region of the controlling semiconductor pattern 810. For example, a control source contact hole penetrating the lower gate insulating layer 121, the lower interlayer insulating layer 131, the separation insulating layer 140, the intermediate insulating layer 150, the upper buffer layer 160, the upper gate insulating layer 122 and the upper interlayer insulating layer 132 may partially expose the control source region of the controlling semiconductor pattern 810. The controlling source electrode 850 may be in direct contact with the control source region of the controlling semiconductor pattern 810 through the control source contact hole.

The controlling drain electrode 870 may include a conductive material. For example, the controlling drain electrode 870 may include a metal, such as aluminum (Al), titanium (Ti), copper (Cu), chrome (Cr), molybdenum (Mo) and tungsten (W). The controlling drain electrode 870 may be insulated from the controlling gate electrode 830. For example, the controlling drain electrode 870 may include a material different from the controlling gate electrode 830. The controlling drain electrode 870 may be disposed on a layer different from the controlling gate electrode 830. The controlling drain electrode 870 may be the same layer as the controlling source electrode 850. For example, the controlling drain electrode 870 may be disposed on the upper interlayer insulating layer 132. The controlling drain electrode 870 may include the same material as the controlling source electrode 850.

The controlling drain electrode 870 may be electrically connected to the control drain region of the controlling semiconductor pattern 810. For example, a control drain contact hole penetrating the lower gate insulating layer 121, the lower interlayer insulating layer 131, the separation insulating layer 140, the intermediate insulating layer 150, the upper buffer layer 160, the upper gate insulating layer 122 and the upper interlayer insulating layer 132 may partially expose the control drain region of the controlling semiconductor pattern 810. The controlling drain electrode 870 may be in direct contact with the control drain region of the controlling semiconductor pattern 810 through the control drain contact hole.

Thus, in the display apparatus according to another embodiment of the present disclosure, S-factor of the driving thin film transistor 400 in each pixel area PA may be increased, regardless of the kind of the controlling thin film transistor 800 for generating the scan signal and/or the data signal. Therefore, in the display apparatus according to another embodiment of the present disclosure, the occurrence of the spot in low grayscale may be effectively prevented.

The display apparatus according to the embodiment of the present disclosure is described that the second light-blocking pattern 720 is disposed between the device substrate 100 and the first switching thin film transistor 200. However, in the display apparatus according to another embodiment of the present disclosure, the external light may be blocked by a difference in refractive index between the insulating layers 110, 121, 131, 140, 150, 160, which are disposed between the device substrate 100 and the first switching thin film transistor 200. Thus, in the display apparatus according to another embodiment of the present disclosure, the second light-blocking pattern 720 may be omitted.

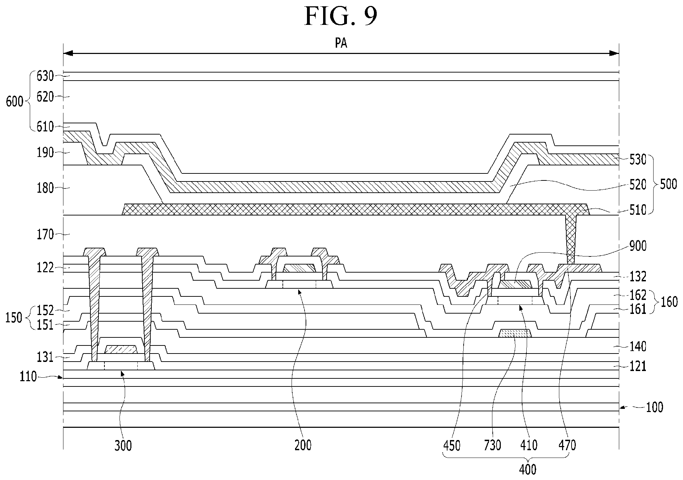

In the display apparatus according to another embodiment of the present disclosure, the driving semiconductor pattern 410 of the driving thin film transistor 400 may be disposed on an upper surface of the driving gate electrode 730 opposite to the device substrate 100, as shown in FIG. 9. For example, the driving gate electrode 730 may be disposed between the separation insulating layer 140 and the driving semiconductor pattern 410. A size of the driving gate electrode 730 may be smaller than a size of the opening penetrating the intermediate insulating layer 150. For example, the driving gate electrode 730 may be disposed in the opening of the intermediate insulating layer 150. Thus, in the display apparatus according to another embodiment of the present disclosure, the upper buffer layer 160 may serve as a gate insulating layer of the driving thin film transistor 400.

A dummy electrode 900 overlapping with the driving channel region of the driving semiconductor pattern 410 may be disposed between the upper gate insulating layer 122 and the upper interlayer insulating layer 132. The dummy electrode 900 may be electrically connected to the driving source electrode 450. Thus, in the display apparatus according to another embodiment of the present disclosure, a parasitic capacitor may be formed between the driving semiconductor pattern 410 and the dummy electrode 900. Referring to the Equation 1, a first parasitic capacitor having a capacitance C1 is formed between the driving semiconductor pattern 410 and the dummy electrode 900, a second parasitic capacitor having a capacitance C2 is formed between the driving gate electrode 730 and the driving semiconductor pattern 410, and the capacitance C1 of the first parasitic capacitor may be greater than the capacitance C2 of the second parasitic capacitor. That is, in the display apparatus according to another embodiment of the present disclosure, the parasitic capacitor formed between the driving semiconductor pattern 410 and the dummy electrode 900 may have the capacitance C1 greater than the capacitance C2 between the driving gate electrode 730 and the driving semiconductor pattern 410, so that the effective gate voltage Veff of the driving thin film transistor 400 may be reduced. Therefore, in the display apparatus according to another embodiment of the present disclosure, the occurrence of the spot in low grayscale may be prevented, regardless of the structure of the driving thin film transistor 400.

In the result, the display apparatus according to the embodiments of the present disclosure may include at least one switching thin film transistor and the driving thin film transistor on the device substrate, wherein the intermediate insulating layer, the upper buffer layer and the gate insulating layer may be stacked on the device substrate, wherein the intermediate insulating layer may include the opening overlapping with the driving semiconductor pattern of the driving thin film transistor, which is disposed between the upper buffer layer and the gate insulating layer, and wherein the light-blocking pattern overlapping with the driving semiconductor pattern may be disposed in the opening of the intermediate insulating layer. Thus, in the display apparatus according to the embodiments of the present disclosure, the current variation value according to the voltage applied to the driving gate electrode of the driving thin film transistor which is disposed on the gate insulating layer may be reduced, without changing the characteristics of the switching thin film transistor. Thereby, in the display apparatus according to the embodiments of the present disclosure, the occurrence of the spot in low grayscale may be prevented.

**Claims**

1. A display apparatus comprising:

   a device substrate (100);
   a first light-blocking pattern (710) on a pixel area (PA) of the device substrate (100);
   an upper buffer layer (160) on the device substrate (100), the upper buffer layer (160) covering the first light-blocking pattern (710);
   a driving thin film transistor (400) on the pixel area (PA) of the device substrate (100), the driving thin film transistor (400) including a driving semiconductor pattern (410) overlapping with the first light-blocking pattern (710); and
   a first intermediate insulating layer (151) between the device substrate (100) and the upper buffer layer (160),
   wherein the first intermediate insulating layer (151) includes a first opening (151h) overlapping with the first light-blocking pattern (710) and the driving semiconductor pattern (410),
   wherein the first opening (151h) has a size larger than the first light-blocking pattern (710) and the driving semiconductor pattern (410).

2. The display apparatus according to claim 1, further comprising a switching thin film transistor (200) on the upper buffer layer (160) of the pixel area (PA),

   wherein the switching thin film transistor (200) includes a switching semiconductor pattern (210) being spaced away from the driving semiconductor pattern (410), and
   wherein the first intermediate insulating layer (151) includes a portion overlapping with the switching semiconductor pattern (210).

3. The display apparatus according to claim 2, wherein the switching semiconductor pattern (210) includes a same material as the driving semiconductor pattern (410).

4. The display apparatus according to claim 2 or 3, further comprising a second light-blocking pattern (720) between the device substrate (100) and the first intermediate insulating layer (151), the second light-blocking pattern (720) overlapping with the switching semiconductor pattern (210).

5. The display apparatus according to claim 4, further comprising a separation insulating layer (140) between the device substrate (100) and the second light-blocking pattern (720),
   wherein the separation insulating layer (140) extends to be disposed between the device substrate (100) and the first light-blocking pattern (710).

6. The display apparatus according to any of claims 1 to 5, further comprising a second intermediate insulating layer (152) between the first intermediate insulating layer (151) and the upper buffer layer (160), wherein the second intermediate insulating layer (152) includes a second opening (152h) overlapping with the first opening (151h).

7. The display apparatus according to any of claims 1 to 6, wherein a driving source electrode (450) of the driving thin film transistor (400) is electrically connected to the first light-blocking pattern (710).

8. The display apparatus according to any of claims 1 to 7, wherein a capacitance of a first parasitic capacitor between the first light-blocking pattern (710) and the driving semiconductor pattern (410) is larger than a capacitance of a second parasitic capacitor between the driving semiconductor pattern (410) and a driving gate electrode (430) of the driving thin film transistor (400).

9. The display apparatus according to claim 1,

wherein the first light-blocking pattern (710) is disposed in the opening (151h) of the first intermediate insulating layer (151); and
wherein the driving thin film transistor (400) is disposed on the upper buffer layer (160); the display apparatus further comprising:

a first switching thin film transistor (200) on the upper buffer layer (160), the first switching thin film transistor (200) including a first switching semiconductor pattern (210) being spaced away from the opening (150h);
an over-coat layer (170) on the first switching thin film transistor (200) and the driving thin film transistor (400); and
a light-emitting device (500) on the over-coat layer (170), the light-emitting device (500) being electrically connected to the driving thin film transistor (400).

10. The display apparatus according to claim 9, wherein the driving semiconductor pattern (410) and the first switching semiconductor pattern (210) include an oxide semiconductor.

11. The display apparatus according to any one of claims 1 to 10, further comprising:

a second switching thin film transistor (300) between the device substrate (100) and the over-coat layer (170), the second switching thin film transistor (300) including a second switching semiconductor pattern (310) and a gate electrode (330) overlapping with a portion of the second switching semiconductor pattern (310); and
a gate insulating layer (121) between the device substrate (100) and the first insulating layer (151), the gate insulating layer (121) extending between the second switching semiconductor pattern (310) and the gate electrode (330).

12. The display apparatus according to claim 11, wherein the second switching semiconductor pattern (310) includes a material different from the driving semiconductor pattern (410) and the first switching semiconductor pattern (210).

13. The display apparatus according to claim 11 or 12, further comprising a second light-blocking pattern (720) being spaced away from the first light-blocking pattern (710), the second light-blocking pattern (720) overlapping with the first switching semiconductor pattern (210),
wherein the second light-blocking pattern (720) is disposed on a same layer as the gate electrode (330) of the second switching thin film transistor (300).

14. The display apparatus according to claim 13, wherein the second light-blocking pattern (720) includes a same material as the gate electrode (330) of the second switching thin film transistor (300).

**Patentansprüche**

1. Anzeigevorrichtung, aufweisend:

ein Vorrichtungssubstrat (100),
ein erstes Lichtblockiermuster (710) auf einem Pixelbereich (PA) des Vorrichtungssubstrats (100),
eine obere Pufferschicht (160) auf dem Vorrichtungssubstrat (100), wobei die obere Pufferschicht (160) das erste Lichtblockiermuster (710) bedeckt,
einen Treiber-Dünnschichttransistor (400) auf dem Pixelbereich (PA) des Vorrichtungssubstrats (100), wobei der Treiber-Dünnschichttransistor (400) ein Treiber-Halbleitermuster (410) aufweist, das das erste Lichtblockiermuster (710) überlappt, und
eine erste Zwischenisolierschicht (151) zwischen dem Vorrichtungssubstrat (100) und der oberen Pufferschicht (160),
wobei die erste Zwischenisolierschicht (151) eine erste Öffnung (151h) aufweist, die das erste Lichtblockiermuster (710) und das Treiber-Halbleitermuster (410) überlappt,
wobei die erste Öffnung (151h) eine Größe hat, die größer als das erste Lichtblockiermuster (710) und das Treiber-Halbleitermuster (410) ist.

2. Anzeigevorrichtung gemäß Anspruch 1, ferner aufweisend einen Schalt-Dünnschichttransistor (200) auf der oberen Pufferschicht (160) des Pixelbereichs (PA),

wobei der Schalt-Dünnschichttransistor (200) ein Schalt-Halbleitermuster (210) aufweist, das im Abstand von dem Treiber-Halbleitermuster (410) angeordnet ist, und
wobei die erste Zwischenisolierschicht (151) einen Abschnitt aufweist, der das Schalt-Halbleitermuster (210) überlappt.

3. Anzeigevorrichtung gemäß Anspruch 2, wobei das Schalt-Halbleitermuster (210) ein gleiches Material wie das Treiber-Halbleitermuster (410) aufweist.

4. Anzeigevorrichtung gemäß Anspruch 2 oder 3, ferner aufweisend ein zweites Lichtblockiermuster (720) zwischen dem Vorrichtungssubstrat (100) und der ersten Zwischenisolierschicht (151), wobei das zweite Lichtblockiermuster (720) das Schalt-Halbleitermuster (210) überlappt.

5. Anzeigevorrichtung gemäß Anspruch 4, ferner aufweisend eine Trennisolierschicht (140) zwischen dem Vorrichtungssubstrat (100) und dem zweiten Lichtblockiermuster (720),
wobei sich die Trennisolierschicht (140) erstreckt, um zwischen dem Vorrichtungssubstrat (100) und dem ersten Lichtblockiermuster (710) angeordnet zu sein.

6. Anzeigevorrichtung gemäß irgendeinem der Ansprüche 1 bis 5, ferner aufweisend eine zweite Zwischenisolierschicht (152) zwischen der ersten Zwischenisolierschicht (151) und der oberen Pufferschicht (160),
wobei die zweite Zwischenisolierschicht (152) eine zweite Öffnung (152h) aufweist, die die erste Öffnung (151h) überlappt.

7. Anzeigevorrichtung gemäß irgendeinem der Ansprüche 1 bis 6, wobei eine Treiber-Source-Elektrode (450) des Treiber-Dünnschichttransistors (400) elektrisch mit dem ersten Lichtblockiermuster (710) verbunden ist.

8. Anzeigevorrichtung gemäß irgendeinem der Ansprüche 1 bis 7, wobei eine Kapazität eines ersten parasitären Kondensators zwischen dem ersten Lichtblockiermuster (710) und dem Treiber-Halbleitermuster (410) größer als eine Kapazität eines zweiten parasitären Kondensators zwischen dem Treiber-Halbleitermuster (410) und einer Treiber-Gate-Elektrode (430) des Treiber-Dünnschichttransistors (400) ist.

9. Anzeigevorrichtung gemäß Anspruch 1,

wobei das erste Lichtblockiermuster (710) in der Öffnung (151h) der ersten Zwischenisolierschicht (151) angeordnet ist, und
wobei der Treiber-Dünnschichttransistor (400) auf der oberen Pufferschicht (160) angeordnet ist,
wobei die Anzeigevorrichtung ferner aufweist:

einen ersten Schalt-Dünnschichttransistor (200) auf der oberen Pufferschicht (160), wobei der erste Schalt-Dünnschichttransistor (200) ein erstes Schalt-Halbleitermuster (210) aufweist, das im Abstand von der Öffnung (150h) angeordnet ist,
eine Überzugsschicht (170) auf dem ersten Schalt-Dünnschichttransistor (200) und dem Treiber-Dünnschichttransistor (400), und
eine lichtemittierende Vorrichtung (500) auf der Überzugsschicht (170), wobei die lichtemittierende Vorrichtung (500) elektrisch mit dem Treiber-Dünnschichttransistor (400) verbunden ist.

10. Anzeigevorrichtung gemäß Anspruch 9, wobei das Treiber-Halbleitermuster (410) und das erste Schalt-Halbleitermuster (210) einen Oxidhalbleiter aufweisen.

11. Anzeigevorrichtung gemäß irgendeinem der Ansprüche 1 bis 10, ferner aufweisend:

einen zweiten Schalt-Dünnschichttransistor (300) zwischen dem Vorrichtungssubstrat (100) und der Überzugsschicht (170), wobei der zweite Schalt-Dünnschichttransistor (300) ein zweites Schalt-Halbleitermuster (310) und eine Gate-Elektrode (330) aufweist, die einen Abschnitt des zweiten Schalt-Halbleitermusters (310) überlappt, und
eine Gate-Isolierschicht (121) zwischen dem Vorrichtungssubstrat (100) und der ersten Isolierschicht (151), wobei sich die Gate-Isolierschicht (121) zwischen dem zweiten Schalt-Halbleitermuster (310) und der Gate-Elektrode (330) erstreckt.

12. Anzeigevorrichtung gemäß Anspruch 11, wobei das zweite Schalt-Halbleitermuster (310) ein Material aufweist, das sich von dem Treiber-Halbleitermuster (410) und dem ersten Schalt-Halbleitermuster (210) unterscheidet.

13. Anzeigevorrichtung gemäß Anspruch 11 oder 12, ferner aufweisend ein zweites Lichtblockiermuster (720), das von dem ersten Lichtblockiermuster (710) im Abstand angeordnet ist, wobei das zweite Lichtblockiermuster (720) das erste Schalt-Halbleitermuster (210) überlappt,
wobei das zweite Lichtblockiermuster (720) auf einer gleichen Schicht wie die Gate-Elektrode (330) des zweiten Schalt-Dünnschichttransistors (300) angeordnet ist.

14. Anzeigevorrichtung gemäß Anspruch 13, wobei das zweite Lichtblockiermuster (720) ein gleiches Material wie die Gate-Elektrode (330) des zweiten Schalt-Dünnschichttransistors (300) aufweist.

## Revendications

1. Dispositif d'affichage comprenant :

   un substrat de dispositif (100) ;
   un premier motif de blocage de lumière (710) sur une zone de pixels (PA) du substrat de dispositif (100) ;
   une couche tampon supérieure (160) sur le substrat de dispositif (100), la couche tampon supérieure (160) recouvrant le premier motif de blocage de lumière (710) ;
   un transistor à couche mince de commande (400) sur la zone de pixel (PA) du substrat de dispositif (100), le transistor à couche mince de commande (400) comprenant un motif semi-conducteur de commande (410) chevauchant le premier motif de blocage de lumière (710) ; et
   une première couche isolante intermédiaire (151) entre le substrat de dispositif (100) et la couche tampon supérieure (160),
   dans lequel la première couche isolante intermédiaire (151) comprend une première ouverture (151h) chevauchant le premier motif de blocage de lumière (710) et le motif semi-conducteur de commande (410),
   dans lequel la première ouverture (151h) a une taille supérieure à celle du premier motif de blocage de lumière (710) et du motif semi-conducteur de commande (410).

2. Dispositif d'affichage selon la revendication **1,** comprenant en outre un transistor à couche mince de commutation (200) sur la couche tampon supérieure (160) de la zone de pixels (PA),

   dans lequel le transistor à couche mince de commutation (200) comprend un motif semi-conducteur de commutation (210) espacé du motif semi-conducteur de commande (410), et dans lequel la première couche isolante intermédiaire (151) comprend une partie chevauchant le motif semi-conducteur de commutation (210).

3. Dispositif d'affichage selon la revendication 2, dans lequel le motif semi-conducteur de commutation (210) comprend un même matériau que celui du motif semi-conducteur de commande (410).

4. Dispositif d'affichage selon la revendication 2 ou 3, comprenant en outre un deuxième motif de blocage de lumière (720) entre le substrat de dispositif (100) et la première couche isolante intermédiaire (151), le deuxième motif de blocage de lumière (720) chevauchant le motif semi-conducteur de commutation (210).

5. Dispositif d'affichage selon la revendication 4, comprenant en outre une couche isolante de séparation (140) entre le substrat de dispositif (100) et le deuxième motif de blocage de lumière (720), dans lequel la couche isolante de séparation (140) s'étend pour être disposée entre le substrat de dispositif (100) et le premier motif de blocage de lumière (710).

6. Dispositif d'affichage selon l'une quelconque des revendications 1 à 5, comprenant en outre une deuxième couche isolante intermédiaire (152) entre la première couche isolante intermédiaire (151) et la couche tampon supérieure (160), dans lequel la deuxième couche isolante intermédiaire (152) comprend une deuxième ouverture (152h) chevauchant la première ouverture (151h).

7. Dispositif d'affichage selon l'une quelconque des revendications 1 à 6, dans lequel une électrode de source de commande (450) du transistor à couche mince de commande (400) est connectée électriquement au premier motif de blocage de lumière (710).

8. Dispositif d'affichage selon l'une quelconque des revendications 1 à 7, dans lequel une capacité d'un premier condensateur parasite entre le premier motif de blocage de lumière (710) et le motif semi-conducteur de commande (410) est supérieure à une capacité d'un deuxième condensateur parasite entre le motif semi-conducteur de commande (410) et une électrode de grille de commande (430) du transistor à couche mince de commande (400).

9. Dispositif d'affichage selon la revendication 1,

   dans lequel le premier motif de blocage de lumière (710) est disposé dans l'ouverture (151h) de la première couche isolante intermédiaire (151) ; et
   dans lequel le transistor à couche mince de commande (400) est disposé sur la couche tampon supérieure (160) ;
   le dispositif d'affichage comprenant en outre :

      un premier transistor à couche mince de commutation (200) sur la couche tampon supérieure (160), le premier transistor à couche mince de commutation (200) comprenant un premier motif semi-conducteur de commutation (210) espacé de l'ouverture (150h) ;
      une couche de recouvrement (170) sur le premier transistor à couche mince de commutation (200) et le transistor à couche mince de commande (400) ; et
      un dispositif électroluminescent (500) sur la couche de recouvrement (170), le dispositif électroluminescent (500) étant connecté électriquement au transistor à couche mince de commande (400).

10. Dispositif d'affichage selon la revendication 9, dans lequel le motif semi-conducteur de commande (410) et le premier motif semi-conducteur de commutation (210) comprennent un semi-conducteur à oxyde.

11. Dispositif d'affichage selon l'une quelconque des revendications 1 à 10, comprenant en outre :

un deuxième transistor à couche mince de commutation (300) entre le substrat de dispositif (100) et la couche de recouvrement (170), le deuxième transistor à couche mince de commutation (300) comprenant un deuxième motif semi-conducteur de commutation (310) et une électrode de grille (330) chevauchant une partie du deuxième motif semi-conducteur de commutation (310) ; et
une couche isolante de grille (121) entre le substrat de dispositif (100) et la première couche isolante (151), la couche isolante de grille (121) s'étendant entre le deuxième motif semi-conducteur de commutation (310) et l'électrode de grille (330).

12. Dispositif d'affichage selon la revendication 11, dans lequel le deuxième motif semi-conducteur de commutation (310) comprend un matériau différent du motif semi-conducteur de commande (410) et du premier motif semi-conducteur de commutation (210).

13. Dispositif d'affichage selon la revendication 11 ou 12, comprenant en outre un deuxième motif de blocage de lumière (720) espacé du premier motif de blocage de lumière (710), le deuxième motif de blocage de lumière (720) chevauchant le premier motif semi-conducteur de commutation (210),
dans lequel le deuxième motif de blocage de lumière (720) est disposé sur une même couche que l'électrode de grille (330) du deuxième transistor à couche mince de commutation (300).

14. Dispositif d'affichage selon la revendication 13, dans lequel le deuxième motif de blocage de lumière (720) comprend un même matériau que celui de l'électrode de grille (330) du deuxième transistor à couche mince de commutation (300).

# FIG. 1

TC

SD

DD

DP

PA

BZ    AA    I    I'

# FIG. 2

PA

630
620
600
610

190
180
170
122
152
150
151
131
112
110
111

530
520  500
510

P1
132
162  160
161
140
121
103
102  100
101

350 310 330 370    P2    250 210 230 270  720    710    450 410 430 470

300              200                      400

# FIG. 3

P1

510

170

122

132

162 } 160
161

d1

152 } 150
151

140

131

151h   710   450  410  430  470   152h

400

# FIG. 4

P2

170

132

122

162 } 160
161

d2

152 } 150
151

140

131

250  210  230  270  720

## FIG. 5

## FIG. 6

# FIG. 7

PA

630
620  600
610
190
180
170
122
152  150
151
131
112  110
111

300       200  720   152h   710   400   151h

530
520  500
510

132
162  160
161
140
121
103
102  100
101

# FIG. 8

BZ          PA

630
620  600
610
180
170
122
152  150
151
131
110

850 810 830 870     152  151     200   720     710    400
800               150

600

530
520  500
510
170
132
162  160
161
140
121
100

FIG. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020210177510
- US 20140183476 A
- US 20210320162 A
- KR 20150101418 A